# EUROPÄISCHE PATENTSCHRIFT

(11) **EP 1 987 217 B1**
(45) Veröffentlichungstag und Bekanntmachung des Hinweises auf die Patenterteilung: **06.01.2010**
(21) Anmeldenummer: 07701301.9
(22) Anmeldetag: 06.02.2007
(51) Int. Cl.: E05B 1/00, A47B 95/02

(54) **EINRICHTUNG ZUM FESTLEGEN EINES TÜR- ODER FENSTERGRIFFES**
MECHANISM FOR SECURING THE HANDLE OF A DOOR OR WINDOW
DISPOSITIF DE FIXATION D'UNE POIGNÉE DE PORTE OU DE FENÊTRE

(30) Priorität: 21.02.2006 AT 2812006
(43) Veröffentlichungstag der Anmeldung: 05.11.2008
(73) Patentinhaber: Evva Sicherheitstechnologie GmbH, 1120 Wien (AT)
(72) Erfinder: NEUMAYER, Harald, A-1220 Wien (AT); PLANK, Walter, A-100 Wien (AT)
(74) Vertreter: Haffner und Keschmann Patentanwälte OG
(86) Internationale Anmeldenummer: PCT/AT2007/000056
(87) Internationale Veröffentlichungsnummer: WO 2007/095650

(56) Entgegenhaltungen:
- GB-A- 2 253 996
- US-A- 2 778 667
- US-A1- 2005 152 742
- US-B1- 6 722 722

## Beschreibung

Die Erfindung bezieht sich auf eine Einrichtung zum Festlegen eines Tür- oder Fenstergriffes oder -knaufes mit einem quer zur Achse des Griffes oder Knaufes angeordneten Feststellglied.

Tür- bzw. Fenstergriffe oder -knäufe sind in unterschiedlichen Formen bekannt. (siehe zum Beispiel Dokument US-A-2778667). Bei der Ausbildung als Knauf sind zumeist rotationssymmetrische Bauteile gebräuchlich, welche in Form eines Pilzkopfes oder einer topfförmigen Struktur symmetrisch zur Rotationsachse ausgebildet sind. Türknäufe können aber auch starr mit einer Tür verriegelt sein und prinzipiell gegen Verdrehung gesichert sein. In anderen Fällen erfolgt die Betätigung eines Schlosses oder einer Falle durch Verdrehen des Knaufes oder Verschwenken des Griffes und es muss eine entsprechende drehfeste Verbindung zu dem Betätigungsteil des Schlosses bzw. der Falle sichergestellt werden. Die häufigste und gebräuchlichste Ausbildung einer derartigen Verbindung besteht in der Verwendung eines Gewindestifts, welche mittels eines Imbusschlüssels an einen zentralen mit dem Schloss verbundenen Teil oder an einem starren mit der Tür oder dem Fenster verbundenen Teil festgelegt wird. Zu diesem Zweck wird der Gewindestift eingeschraubt und angepresst. In aller Regel beschränkt sich die kraftschlüssige Verbindung hierbei auf den Endbereich des Gewindestifts, welcher zumeist spitz verlaufend ausgebildet wird, um entsprechende Kräfte aufzubringen. Bei starken Erschütterungen und häufiger Betätigung kann sich aber eine derartige Feststellschraube auch lockern, wodurch der Knauf bzw. der Griff zunächst in axialer Richtung verschieblich wird, bevor er abfallen kann oder abgenommen werden kann. Zur Verbindung von Ausbildungen eines Knaufes mit großem Durchmesser in der Verbindungsebene sind derartige Feststellschrauben nur dann geeignet, wenn eine Mehrzahl derartiger Schrauben über den Umfang verteilt angeordnet wird, um ein gewisses Maß an Sicherheit zu erreichen. Mit einer derartigen Mehrzahl von Schrauben erhöht sich aber auch der Montageaufwand beträchtlich.

Die Erfindung zielt nun darauf ab, eine Einrichtung der eingangs genannten Art zu schaffen, mit welcher eine drehsichere und gegen axiale Verschiebung gesicherte Festlegung eines Türgriffes oder -knaufes auch dann mit Sicherheit gelingt, wenn die Festlegung an Teilen relativ großen Durchmessers erfolgen soll, wie dies beispielsweise bei Verwendung einer Knaufscheibe der Fall ist, wobei der aufzusetzende Knauf dann einen Hohlraum abschließt, in welchen gewünschtenfalls weitere Bauteile untergebracht werden können.

Zur Lösung dieser Aufgabe besteht die erfindungsgemäße Einrichtung im Wesentlichen darin, dass ein Verschlussfederelement in einem Basisteil bzw. einer Knaufscheibe angeordnet ist, dass das Verschlussfederelement in radiale Durchbrechungen des Basisteils bzw. der Knaufscheibe eintauchende Sperrnasen trägt und dass das Feststellglied mit dem Verschlussfederelement zusammenwirkt, sodass bei einer Verschiebung des Feststellglieds quer zur Achse des Griffes oder Knaufes das Verschlussfederelement verformt wird und am Umfang des Verschlussfederelements angeordnete Sperrnasen außer Eingriff bzw. in Eingriff mit Ausnehmungen an oder in einem das Verschlussfederelement und das Basisteil bzw. die Knaufscheibe umgreifenden Teil des Griffes oder Knaufs gelangen.

Dadurch, dass in einem Basisteil bzw. einer Knaufscheibe ein Verschlussfederelement angeordnet ist, welches selbst wiederum mit einem Feststellglied zusammenwirkt, wird die Möglichkeit geschaffen durch Verformen einer derartigen Verschlussfeder an einer derartigen Verschlussfeder angeordnete Sperrnasen außer Eingriff bzw. in Eingriff mit entsprechenden Verriegelungsausnehmungen am Innenumfang des zu verbindenden Griffes oder Knaufes zu bringen. Bei entsprechender Gestaltung des Verschlussfederelementes genügt hierbei ein einziges Feststellglied, welches gleichzeitig eine Mehrzahl von Sperrnasen in Eingriff oder außer Eingriff bringen kann. Auf diese Weise kann sichergestellt werden, dass diese Mehrzahl von über den Umfang verteilten Sperrnasen einen aufgesteckten Knauf bzw. Griff auch auf großen Durchmessern sowohl drehsicher als auch gegen axiales Abziehen gesichert verriegeln, wobei gegen ein Abziehen gleichzeitig eine Mehrzahl von über den Umfang verteilt angeordneten Sperrnasen wirksam wird. Die Verriegelung kann in einfacher Weise durch Lösen der Schraube erfolgen, sodass in der Verriegelungslage lediglich die Federkraft eine axiale Verschiebung oder eine Verschwenkung behindert. Dies stellt gleichzeitig sicher, dass bei Erschütterungen, welche ein Lockern des Feststellgliedes zur Folge haben könnten, die Festigkeit der Verbindung in keiner Weise beeinträchtigt wird.

In besonders vorteilhafter Weise ist die Ausbildung hierbei so getroffen, dass das Feststellglied als Schraube, insbesondere Gewindestift, ausgebildet ist. Durch Einschrauben einer derartigen Schraube gelingt es, das erfindungsgemäße Verschlussfederelement entsprechend zu verformen, um die Sperrnasen außer Eingriff zu bringen. Hierbei ist mit Vorteil die Ausbildung so getroffen, dass das Verschlussfederelement als radial geschlitztes im Wesentlichen ringförmiges Federblatt ausgebildet ist und am Umfang zu beiden Seiten des radialen Schlitzes in Durchbrechungen des Basisteils bzw. der Knaufscheibe eintauchende Sperrasen bzw. Vorsprünge trägt, welche bei radialer Kompression der Federblätter einwärts schwenken, wobei vorzugsweise das Verschlussfederelement zu beiden Seiten der Angriffstelle des Feststellglieds am Umfang vorragende Sperrnasen aufweist, welche in Schlitze des das Feststellglied aufnehmenden Grundkörpers eintauchen und durch Betätigen des Feststellglieds außer Eingriff mit zu den Sperrasen korrespondierenden Ausnehmungen des auf den Basisteil bzw. die Knaufscheibe aufgesteckten Griffes oder Knaufes bringbar sind. Das Verschlussfederelement weist somit über den Umfang verteilt nicht nur dem Angriff des Feststellgliedes benachbart, sondern auch nahe den freien Enden und damit nahe dem in Umfangsrichtung nachfolgenden Schlitz entsprechende Sperrnasen auf, wodurch gleichzeitig an mehreren Stellen des Umfangs eine sichere Verriegelung zwischen dem Basisteil bzw. der Knaufscheibe und dem Griff oder Knauf gelingt.

Der Knauf selbst kann hierbei, wie bereits erwähnt, beispielsweise topfförmig ausgebildet sein, sodass im Inneren eines derartigen Knaufes in dem zwischen Knaufscheibe und Knauf gebildeten Hohlraum beispielsweise Teile einer elektronischen Schlüsselerkennungslogik geschützt untergebracht werden können.

In besonders vorteilhafter Weise ist die Ausbildung so getroffen, dass die freien dem radialen Schlitz benachbarten Enden des Verschlussfederelements im Anschluss an die in die Durchbrechung des Basisteils bzw. der Knaufscheibe eintauchenden Sperrnasen einwärts verrundet oder spitzwikelig zur Tangente an das Federblatt einwärts verlaufend ausgebildet oder gegenüber dem Radius des Verschlussfederelements mit kleinerem Radius ausgebildet sind. Eine derartige Ausbildung stellt sicher, dass bei einem Einschrauben des Feststellgliedes nicht nur dem Feststellglied benachbarte Sperrnasen außer Eingriff gepresst werden, sondern auch die freien, dem radialen Schlitz benachbarten Enden der Verschlussfederelemente in einer Weise einwärts gebogen werden, welche die dort angeordneten Sperrnasen einwärts verschwenkt und damit außer Eingriff bringt. Diese gegenüber dem Radius des Verschlussfederelementes mit kleinerem Radius ausgebildeten oder spitzwinkelig zur Tangente verlaufenden Endbereiche des Federblatts laufen an einer Kante einer Durchbrechung des Basisteils bzw. der Knaufscheibe auf und bewirken auf diese Weise bei einer Verformung der Feder die entsprechende Verschwenkung.

Um eine Verlustsicherung für das Feststellglied zu schaffen und gleichzeitig sicherzustellen, dass auch ein gegebenenfalls verbleibendes Spiel in radialer Richtung sicher verspannt werden kann, ist die Ausbildung mit Vorteil so getroffen, dass das Feststellglied an seinem radial äußeren Ende einen die lichte Weite der radialen Durchbrechung des Knaufes für das Einbringen eines Schraubendrehwerkzeuges übersteigende Durchmesser aufweist. Bei einem Herausschrauben des Feststellglieds entspannt sich zunächst das Federelement, wobei die Sperrnasen durch die entsprechenden Durchbrechungen im Basisteil bzw. der Knaufscheibe hindurch treten und die Verriegelung bewirken, worauf anschließend bei einem weiteren Herausschrauben des Feststellglieds der Kopf desselben mit der Innenkontur des Knaufes oder Griffes kollidiert, da er durch die entsprechende Durchbrechung auf Grund seiner Dimensionen nicht hindurch treten kann. Diese Kollision führt bei entsprechendem Verdrehen der Schraube zu einer Arretierung gegen geringfügig radiale Verschiebungen, sofern diese noch möglich gewesen wären.

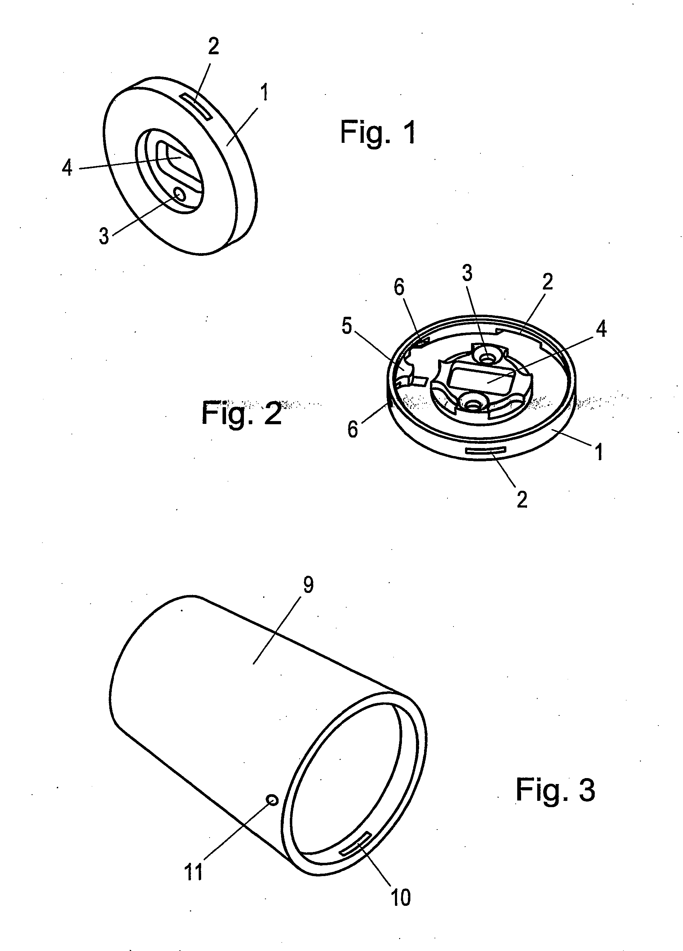

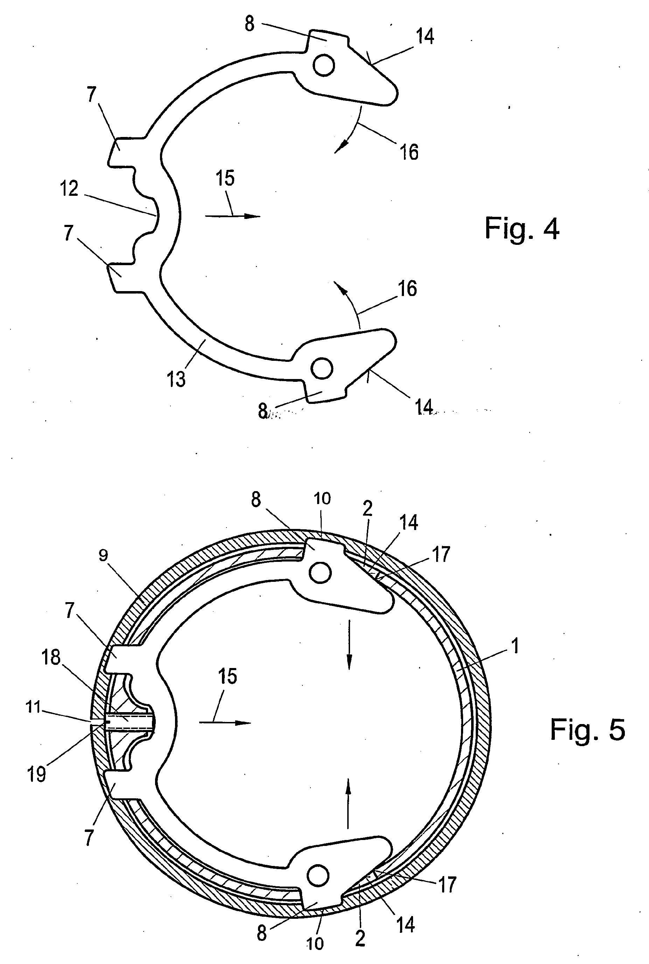

Die Erfindung wird nachfolgend anhand eines in der Zeichnung schematisch dargestellten Ausführungsbeispiels näher erläutert. In dieser zeigen Fig.1 eine perspektivische Ansicht einer Knaufscheibe, Fig.2 die perspektivische Ansicht der Knaufscheibe nach Fig.1 von der Innenseite her gesehen, Fig.3 einen Knauf, welcher mit der Knaufscheibe nach Fig.1 oder 2 drehfest und gegen axiale Verschiebung gesichert verbunden werden soll, Fig.4 eine vergrößerte Darstellung eines zu diesem Zweck eingesetzten Verschlussfederelements und Fig.5 das Verschlussfederelement nach Fig.4 in einer in eine Knaufscheibe eingesetzten Lage teilweise im Schnitt.

In Fig.1 ist eine Knaufscheibe 1 ersichtlich, an deren Umfang Durchbrechungen 2 vorgesehen sind. Die Knaufscheibe 1 kann über nicht dargestellte und die Bohrungen 3 durchsetzende Schrauben starr festgelegt werden oder mit einem weiteren Bauteil verbunden werden. In die polygonale Aufnahmeöffnung 4 kann ein entsprechendes Stellglied eingesetzt werden, mit welchem eine Falle oder ein Schloss betätigt wird. Durch diese Öffnung können aber auch entsprechende Wellen hindurchgeführt werden.

Bei der Darstellung nach Fig.2 sind mehrere Durchbrechungen 2 ersichtlich. In den ein Gewinde tragenden Bauteil 5 kann eine Feststellschraube 18 eingesetzt werden. In Fig.2 ist das in Fig.4 vergrößert dargestellte Verschlussfederelement 13 nicht eingezeichnet. Zusätzlich zu den Durchbrechungen 2 sind aber mit 6 dem Bauteil 5 für die Aufnahme des Feststellglieds 18 benachbarte Schlitze bezeichnet, durch die ebenso wie durch die Durchbrechungen 2 Sperrnasen hindurch treten können, wie sie in Fig.4 mit 7 und mit 8 bezeichnet sind.

In Fig.3 ist ein Knauf 9 ersichtlich, dessen innerer Umfang nahe der Öffnung wiederum Ausnehmungen 10 aufweist, welche in eine entsprechend fluchtende Position zu den Durchbrechungen 2 bzw. Schlitzen 6 der Knaufscheibe 1 gebracht werden müssen. Zu diesem Zweck muss die Durchbrechung 11 in fluchtende Position mit dem Feststellglied gebracht werden, sodass durch Einführen eines Schraubendrehers oder Imbusschlüssels das Feststellglied 18 in Form einer Schraube bzw. eines Gewindestifts entsprechend ein- oder ausgeschraubt werden kann.

Das in Fig.4 vergrößert dargestellte Verschlussfederelement 13 trägt, wie bereits erwähnt, die Sperrnasen 7 und 8. Die Sperrnasen 7 sind hierbei der Angriffsstelle 12 für das Feststellglied 18 benachbart angeordnet. In der entspannten Position des Federblatts 13 gelangen die Sperrnasen 8 durch die Durchbrechungen 2 hindurch nach außen, wobei das Verschlussfederelement bzw. Federblatt 13 über die Schrägflächen 14 in Anlage an einen Rand dieser Durchbrechungen 2 gelangt. Bei einem Eindrehen des Gewindestifts 18 in Richtung des Pfeiles 15 ist nun unmittelbar verständlich, dass die beiden Sperrnasen 7 ebenso in Richtung des Pfeils 15 bewegt werden und damit in die Schlitze 6 der Knaufscheibe 1 zurückgezogen werden. Gleichzeitig laufen die Schrägflächen 14 auf die Kanten der Durchbrechungen 2 auf, wodurch die Sperrnasen 8 in Richtung der Pfeile 16 einwärts verschwenkt werden und gleichfalls in die Durchbrechungen 2 zurückgezogen werden und nicht mehr über den Außenumfang der Knaufscheibe 1 vorragen. Gleichzeitig kommen derartige Sperrnasen somit außer Eingriff mit der in Fig.3 dargestellten Ausnehmung 10 am Innenumfang des Knaufes 9, wodurch dieser abgezogen werden kann.

Die Funktionsweise lässt sich in Fig.5 schematisch besonders deutlich erkennen. In Fig.5 wurden hierbei die gewählten Bezugszeichen aus den Fig.1 bis 4 beibehalten, wobei in der entspannten Lage die Enden der Durchbrechungen 2, welche mit den Schrägflächen 14 der freien Enden des geschlitzten Verschlussfederelements 13 zusammenwirken, mit 17 bezeichnet sind. In Fig.5 ist das als Gewindestift ausgebildete Feststellglied mit 18 bezeichnet und weist eine Stirnfläche 19 auf, welche größer als der lichte Durchmesser der Durchbrechung 11 für das Betätigungswerkzeug ist, sodass bei einem Herausschrauben der Gewindestift 18 am Innenumfang des Knaufes 9 aufläuft und diesen gegen eine Bewegung in radialer Richtung sichert. Gleichzeitig wird das Federblatt 18 entgegen der Richtung des Pfeils 15 entspannt, wodurch die Sperrnasen 8 bzw. 7 wiederum durch die Wand der Knaufscheibe 1 hindurchtauchen und in eine entsprechende Verriegelungsposition mit Ausnehmungen am Innenumfang des Knaufes 9 gebracht werden.

## Patentansprüche

1. Einrichtung zum Festlegen eines Tür- oder Fenstergriffes oder -knaufes mit einem quer zur Achse des Griffes oder Knaufes (9) angeordneten Feststellglied, **dadurch gekennzeichnet, dass** ein Verschlussfederelement (13) in einem Basisteil bzw. einer Knaufscheibe (1) angeordnet ist, dass das Verschlussfederelement (13) in radiale Durchbrechungen (2,6) des Basisteils bzw. der Knaufscheibe (1) eintauchende Sperrnasen (8,7) trägt und dass das Feststellglied mit dem Verschlussfederelement (13) zusammenwirkt, sodass bei einer Verschiebung des Feststellglieds quer zur Achse des Griffes oder Knaufes (9) das Verschlussfederelement (13) verformt wird und am Umfang des Verschlussfederelements (13) angeordnete Sperrnasen (8) außer Eingriff bzw. in Eingriff mit Ausnehmungen (10) an oder in einem das Verschlussfederelement (13) und das Basisteil bzw. die Knaufscheibe (1) umgreifenden Teil des Griffes oder Knaufs (9) gelangen.

2. Einrichtung nach Anspruch 1, **dadurch gekennzeichnet, dass** das Feststellglied als Schraube (18), insbesondere Gewindestift, ausgebildet ist.

3. Einrichtung nach Anspruch 1 oder 2, **dadurch gekennzeichnet, dass** das Verschlussfederelement als radial geschlitztes, im Wesentlichen ringförmiges Federblatt (13) ausgebildet ist und am Umfang zu beiden Seiten des radialen Schlitzes in Durchbrechungen (2) des Basisteils bzw. der Knaufscheibe (1) eintauchende Sperrnasen (8) bzw. Vorsprünge trägt, welche bei radialer Kompression der Federblätter einwärts schwenken.

4. Einrichtung nach einem der Ansprüche 1, 2 oder 3, **dadurch gekennzeichnet, dass** das Verschlussfederelement (13) zu beiden Seiten der Angriffstelle (12) des Feststellglieds am Umfang vorragende Sperrnasen (7) aufweist, welche in Schlitze (6) des das Feststellglied (18) aufnehmenden Grundkörpers eintauchen und durch Betätigen des Feststellglieds (18) außer Eingriff mit zu den Sperrasen (7) korrespondierenden Ausnehmungen (6) des auf den Basisteil bzw. die Knaufscheibe (1) aufgesteckten Griffes oder Knaufes (9) bringbar sind.

5. Einrichtung nach einem der Ansprüche 1 bis 4, **dadurch gekennzeichnet, dass** die freien dem radialen Schlitz benachbarten Enden des Verschlussfederelements (13) im Anschluss an die in die Durchbrechungen (2) des Basisteils bzw. der Knaufscheibe (1) eintauchenden Sperrnasen (8) einwärts verrundet oder spitzwinkelig zur Tangente an das Federblatt (13) einwärts verlaufend ausgebildet oder gegenüber dem Radius des Verschlussfederelements (13) mit kleinerem Radius ausgebildet sind.

6. Einrichtung nach einem der Ansprüche 1 bis 5, **dadurch gekennzeichnet, dass** das Feststellglied (18) an seinem radial äußeren Ende einen die lichte Weite der radialen Durchbrechung (11) des Knaufes (9) für das Einbringen eines Schraubendrehwerkzeuges übersteigenden Durchmesser aufweist.

## Claims

1. A device for securing the handle or knob of a door or window, comprising a locking element that is disposed transversely to the axis of the handle or knob (9), **characterised in that** a locking spring element (13) is disposed in a base part or a knob shield (1), that the locking spring element carries locking lugs (8, 7) that dip into radial openings (2, 6) of the base part or the knob shield (1) and that the locking element interacts with the locking spring element (13) in such a manner that the locking spring element (13) is deformed when the locking element is displaced transversely to the axis of the handle or knob (9) and locking lugs (8), disposed on the periphery of the locking spring element (13), disengage from or engage with recesses (10) on or in a part of the handle or knob (9) encompassing the locking spring element (13) and the base part or the knob shield (1).

2. The device according to claim 1, **characterised in that** the locking element is configured as a screw (18), in particular a threaded pin.

3. The device according to claim 1 or 2, **characterised in that** the locking spring element is configured as a radially slitted, substantially annular spring leaf (13) and carries locking lugs (8) or projections that dip into openings (2) of the base part or the knob shield (1) on the periphery on both sides of the radial slit, which lugs pivot inwards during radial compression of the leaf springs.

4. The device according to any one of claims 1, 2 or 3, **characterised in that** on both sides of the point of application (12) of the locking element on the periphery, the locking spring element (13) has protruding locking lugs (7) which dip into slits (6) in the base body accommodating the locking element (18) and by actuating the locking element (18), can be brought out of engagement with recesses (6) of the handle or knob (9) placed on the base part or the knob shield (1), which correspond to the locking lugs (7).

5. The device according to any one of claims 1 to 4, **characterised in that** the free ends of the locking spring element (13) adjacent to the radial slit, which follow the locking lugs (8) that dip into the openings (2) of the base part or the knob shield (1) are inwardly rounded or are configured as running inwards at an acute angle to the tangent to the spring leaf (13) or are configured as having a smaller radius compared with the radius of the locking spring element (13).

6. The device according to any one of claims 1 to 5, **characterised in that** at its radially outer end the locking element (18) has a diameter exceeding the inside width of the radial opening (11) of the knob (9) for the insertion of a screwdriver tool.

## Revendications

1. Dispositif de fixation d'une poignée ou d'un bouton de porte ou de fenêtre comprenant un organe de blocage disposé transversalement à l'axe de la poignée ou du bouton (9), **caractérisé en ce qu'**un élément ressort de verrouillage (13) est disposé dans une partie de base ou un disque de poignée (1), **en ce que** l'élément ressort de verrouillage (13) porte des becs d'encliquetage (8, 7) pénétrant dans des découpures (2, 6) radiales de la partie de base ou du disque de poignée (1) et **en ce que** l'organe de blocage coopère avec l'élément ressort de verrouillage (13) de façon qu'en cas de déplacement de l'organe de blocage dans une direction transversale à l'axe de la poignée ou du bouton (9) l'élément ressort de verrouillage (13) soit déformé et que les becs d'encliquetage (8) disposés sur le pourtour de l'élément ressort de verrouillage (13) se dégagent de ou viennent en prise avec des évidements (10) sur ou dans une partie de la poignée ou du bouton (9) entourant l'élément ressort de verrouillage (13) et la partie de base ou le disque de poignée (1).

2. Dispositif selon la revendication 1, **caractérisé en ce que** l'organe de blocage est conçu sous forme de vis (18), en particulier de tige filetée.

3. Dispositif selon la revendication 1 ou 2, **caractérisé en ce que** l'élément ressort de verrouillage est conçu sous forme de lame ressort (13) sensiblement annulaire et fendue radialement et porte, sur la périphérie, des deux côtés de la fente radiale, des becs d'encliquetage (8) ou saillies pénétrant dans des découpures (2) de la partie de base ou du disque de poignée (1), qui pivotent vers l'intérieur en cas de compression radiale des lames ressort.

4. Dispositif selon l'une des revendications 1, 2 ou 3, **caractérisé en ce que** l'élément ressort de verrouillage (13) présente, des deux côtés du point d'attaque (12) de l'organe de blocage, des becs d'encliquetage (7) faisant saillie sur la périphérie, lesquels pénètrent dans des fentes du corps de base recevant l'organe de blocage (18) et, par actionnement de l'organe de blocage (18), peuvent être dégagés d'évidements (6), correspondant aux becs d'encliquetage (7), de la poignée ou du bouton (9) rapporté sur la partie de base ou le disque de poignée (1).

5. Dispositif selon l'une des revendications 1 à 4, **caractérisé en ce que** les extrémités libres de l'élément ressort de verrouillage (13), adjacentes à la fente radiale, suite aux becs d'encliquetage (8) pénétrant dans les découpures (2) de la partie de base ou du disque de poignée (1) sont arrondies vers l'intérieur ou s'étendent vers l'intérieur en formant un angle aigu par rapport à la tangente à la lame ressort (13) ou sont réalisées avec un rayon plus petit que le rayon de l'élément ressort de verrouillage (13).

6. Dispositif selon l'une des revendications 1 à 5, **caractérisé en ce que** l'organe de blocage (18) présente, sur son extrémité radialement extérieure, un diamètre dépassant la largeur intérieure de la découpure radiale (11) du bouton (9) pour l'introduction d'un tournevis.
